# EUROPÄISCHE PATENTSCHRIFT

(11) **EP 1 148 549 B1**
(45) Veröffentlichungstag und Bekanntmachung des Hinweises auf die Patenterteilung: **21.02.2007**
(21) Anmeldenummer: 01108512.3
(22) Anmeldetag: 04.04.2001
(51) Int. Cl.: H01L 23/66, H01L 23/528, G11C 11/4074

(54) **Integrierte Schaltung mit integrierter HF-Filtereinrichtung**
Integrated circuit with integrated HF filter
Circuit intégré avec un filtre HF

(30) Priorität: 20.04.2000 DE 10019811
(43) Veröffentlichungstag der Anmeldung: 24.10.2001
(73) Patentinhaber: Infineon Technologies AG, 81669 München (DE)
(72) Erfinder: Held, Joachim, 81739 München (DE); Steinecke, Thomas, 85457 Hofsingelding (DE)
(74) Vertreter: Jannig, Peter

(56) Entgegenhaltungen:
- EP-A- 0 871 221
- EP-A- 0 930 619
- US-A- 5 710 740

## Beschreibung

Die vorliegende Erfindung betrifft eine Vorrichtung gemäß dem Oberbegriff des Anspruchs 1.

Integrierte Schaltungen sind seit vielen Jahren in unzähligen Ausführungsformen bekannt und bedürfen keiner näheren Erläuterung.

Ein bekanntes Problem von integrierten Schaltungen besteht darin, daß diese mitunter empfindlich auf hochfrequente Störsignale reagieren und selbst (beispielsweise durch die Erzeugung von Signalen mit steilen Flanken) hochfrequente Störsignale erzeugen, die andere Komponenten des die integrierte Schaltung enthaltenden Systems stören können.

Um dies zu vermeiden, werden bislang außerhalb der integrierten Schaltung vorgesehene externe Filter und/oder besondere Layouts der integrierten Schaltung und/oder der die integrierte Schaltung enthaltenden Anordnung verwendet.

Weitere Möglichkeiten zur Beseitigung der genannten Störungen sind aus der EP-A-0 930 619, der US-A-5 710 740, und der EP-A-0 871 221 bekannt.

Die Erfahrung zeigt, daß es trotz der bekannten Maßnahmen nicht immer und überall möglich ist, das genannte Problem zu beseitigen.

Der vorliegenden Erfindung liegt daher die Aufgabe zugrunde, eine Möglichkeit zu finden, durch welche es sich auf einfache Art und Weise zuverlässig vermeiden läßt, daß der Betrieb von integrierten Schaltungen durch hochfrequente Störsignale gestört wird, und/oder daß integrierte Schaltungen oder sonstige Systemkomponenten durch von integrierten Schaltungen erzeugte hochfrequente Störsignale gestört werden.

Diese Aufgabe wird durch die in Anspruch 1 beanspruchte integrierte Schaltung gelöst.

Die erfindungsgemäße integrierte Schaltung enthält eine einen ersten Kondensator, einen zweiten Kondensator, und einen Widerstand aufweisende HF-Filtereinrichtung,
- wobei der erste Kondensator die Leitung, von welcher die HF-Filtereinrichtung die hochfrequenten Störsignale entfernen soll, mit einem Bezugspotential verbindet,
- wobei der zweite Kondensator die Leitung, von welcher die HF-Filtereinrichtung die hochfrequenten Störsignale entfernen soll, mit einem Bezugspotential verbindet, und
- wobei der Widerstand zwischen dem ersten Kondensator und dem zweiten Kondensator in die Leitung, von welcher die HF-Filtereinrichtung die hochfrequenten störsignale entfernen soll, eingefügt ist.

Die Integration einer solchen HF-Filtereinrichtung in die integrierte Schaltung erweist sich in vielfacher Hinsicht als besonders vorteilhaft:

Einer der Vorteile besteht darin, daß eine in der integrierten Schaltung vorgesehene HF-Filtereinrichtung HF-Störsignale, die in die integrierte Schaltung gelangen und/oder in dieser erzeugt werden, äußert wirksam abblocken kann. Dies hat zwei Gründe: einerseits, weil die HF-Störsignale unmittelbar dort herausgefiltert werden können, wo deren Auftreten stören würde bzw. wo sie erzeugt werden, und andererseits, weil die Elemente, aus denen die HF-Filtereinrichtung aufgebaut ist, also insbesondere ein oder mehrere Kondensatoren und gegebenenfalls ein oder mehrere Widerstände, optimal dimensioniert werden können und ihre Eigenschaften unter allen Umständen im wesentlichen unverändert beibehalten.

Dadurch, daß die HF-Störsignale unmittelbar dort herausgefiltert werden können, wo deren Auftreten stören würde bzw. wo sie erzeugt werden, lassen sich durch die HF-Filtereinrichtung auch Störsignale herausfiltern, die erst innerhalb der integrierten Schaltung entstehen. Hierzu gehören insbesondere solche Störsignale, die durch Bestandteile der zu schützenden integrierten Schaltung selbst erzeugt werden und/oder Störsignale, die durch das Einwirken von elektromagnetischer Strahlung auf innerhalb der integrierten Schaltung verlaufende Leitungen in die integrierte Schaltung hineingetragen werden. Vor solchen Störsignalen können externe Filter nicht schützen.

Daß in die integrierte Schaltung integrierte HF-Filtereinrichtungen optimal dimensioniert werden können liegt daran, daß die Eigenschaften von den dafür verwendeten Komponenten, d.h. die Kapazitäten, Widerstände, etc. problemlos exakt an die individuellen Bedürfnisse anpaßbar sind; im Gegensatz hierzu müssen die für externe Filter benötigten diskreten Bauelemente unter den am Markt verfügbaren, im allgemeinen nur vorbestimmte Standardwerte aufweisenden Bauelementen ausgewählt werden, wodurch externe Filter allenfalls zufällig genau die gewünschten Eigenschaften aufweisen.

Daß in die integrierte Schaltung integrierte HF-Filtereinrichtungen ihre Eigenschaften unter allen Umständen im wesentlichen unverändert beibehalten, liegt insbesondere daran, daß in integrierte Schaltungen integrierte Kondensatoren im wesentlichen ausschließliche kapazitive Eigenschaften aufweisen. Im Gegensatz hierzu weisen als diskrete Elemente gebildete Kondensatoren zusätzlich auch induktive Eigenschaften auf. Das Ersatzschaltbild eines solchen Kondensators besteht aus einer Reihenschaltung eines Kondensators und einer Spule, wodurch ein Kondensator in Form eines diskreten Bauelementes genau genommen ein LC-Serienschwingkreis ist. LC-Serienschwingkreise weisen bekanntlich für unterhalb der Resonanzfrequenz liegende Frequenzen kapazitive Eigenschaften, und für oberhalb der Resonanzfrequenz liegende Frequenzen induktive Eigenschaften auf. Ein unter Verwendung eines Kondensators in Form eines diskreten Bauelementes aufgebautes externes Filter kann seine Aufgabe daher nur für unterhalb der Resonanzfrequenz liegende Frequenzen erfüllen. In integrierte Schaltungen integrierte Kondensatoren werden durch elektrisch leitende Strukturen auf übereinander liegenden Schichten der integrierten Schaltung gebildet und weisen daher keine oder vernachlässigbar geringe induktive Eigenschaften auf. Dadurch können solche Kondensatoren die ihnen obliegende Aufgabe bis in die höchsten Frequenzbereiche hinein erfüllen.

Durch das Vorsehen einer in die integrierte Schaltung integrierten HF-Filtereinrichtung entfällt zumindest teilweise die Notwendigkeit, externe Filter vorsehen zu müssen und/oder besondere Layouts verwenden zu müssen.

HF-Filtereinrichtung lassen sich einfach und problemlos in integrierte Schaltungen integrieren, so daß sich die genannten Vorteile ohne Inkaufnahme von nennenswerten Nachteilen erzielen lassen.

Die Integration einer HF-Filtereinrichtung in eine integrierte Schaltung ist damit eine sehr einfache, aber dennoch unter allen Umständen äußerst wirkungsvolle Möglichkeit, um zu verhindern, daß der Betrieb von integrierten Schaltungen durch hochfrequente Störsignale gestört wird, und/oder daß andere integrierte Schaltungen oder sonstige Systemkomponenten durch von integrierten Schaltungen erzeugte hochfrequente Störsignale gestört werden.

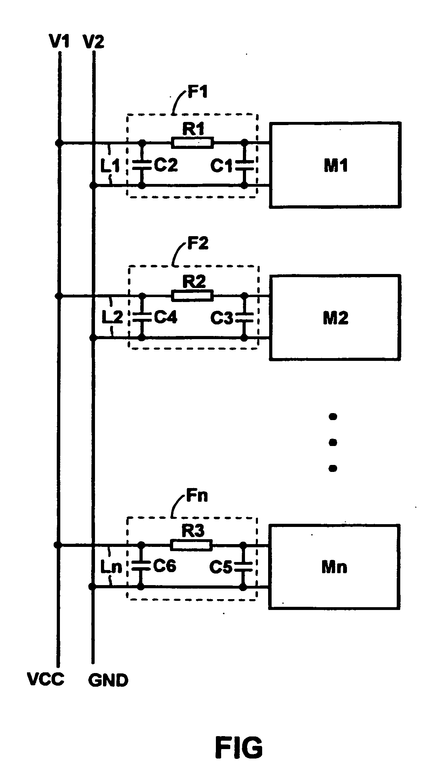

Vorteilhafte Weiterbildungen der Erfindung sind den Unteransprüchen, der folgenden Beschreibung, und der Figur entnehmbar.

Die Erfindung wird nachfolgend anhand eines Ausführungsbeispiels unter Bezugnahme auf die Figur näher beschrieben.

Die Figur zeigt eine integrierte Schaltung mit einem Ausführungsbeispiel der im folgenden näher beschriebenen HF-Filtereinrichtung.

Die im folgenden näher beschriebene integrierte Schaltung ist eine beliebige integrierte Schaltung, also beispielsweise ein Mikroprozessor, ein Mikrocontroller, ein Speicherbaustein oder eine beliebige andere integrierte Schaltung.

Der Vollständigkeit halber sei bereits an dieser Stelle darauf hingewiesen, daß von der vorliegend betrachteten integrierten Schaltung nur die hier besonders interessierenden Bestandteile gezeigt und beschrieben sind. Der Aufbau, die Funktion und die Wirkungsweise der nicht gezeigten Bestandteile der integrierten Schaltung sind bekannt und bedürfen keiner näheren Erläuterung.

Die betrachtete integrierte Schaltung zeichnet sich dadurch aus, daß in dieser eine HF-Filtereinrichtung integriert ist, durch welche die Ausbreitung von hochfrequenten Störsignalen über Gleichspannungen oder niederfrequente Spannungen führende Leitungen unterbindbar oder einschränkbar ist.

Die betrachtete integrierte Schaltung umfaßt eine Vielzahl von Modulen M1, M2, ... Mn, die über separate Leitungspaare L1, L2, ... Ln mit zur Stromversorgung der Module dienenden Versorgungsleitungen V1 und V2 verbunden sind, wobei die Versorgungsleitung V1 ein hier mit VCC bezeichnetes positives Potential führt, und wobei die Versorgungsleitung V2 ein mit GND bezeichnetes neutrales Potential (Massepotential) führt.

Die Module M1, M2, ... Mn beinhalten im betrachteten Beispiel jeweils bestimmte Funktionseinheiten der integrierten Schaltung, d.h. das Modul M1 beispielsweise einen Speicherblock, das Modul M2 beispielsweise einen oder mehrere I/O-Treiber, das Modul Mn beispielsweise einen A/D-Wandler, usw.

Für jedes Modul ist eine eigene HF-Filtereinrichtung F1, F2, . . . Fn vorgesehen. Diese HF-Filtereinrichtungen sind im betrachteten Beispiel so angeordnet, daß über sie die Ausbreitung von hochfrequenten Störsignalen über die Leitungen L1, L2, ... Ln und die Versorgungsleitungen V1 und V2 unterbindbar oder einschränkbar ist.

Zu den Versorgungsleitungen V1, V2 sei bereits an dieser Stelle angemerkt, daß diese als Leitungen oder als flächenhafte Gebilde in der selben oder in verschiedenen Ebenen der integrierten Schaltung ausgebildet sein können.

Die dem ersten Modul M1 zugeordnete HF-Filtereinrichtung F1 umfaßt einen ersten Kondensator C1, einen zweiten Kondensator C2, und einen Widerstand R1; die dem zweiten Modul M2 zugeordnete HF-Filtereinrichtung F2 umfaßt einen ersten Kondensator C3, einen zweiten Kondensator C4, und einen Widerstand R2; die dem dritten Modul M3 zugeordnete HF-Filtereinrichtung F3 umfaßt einen ersten Kondensator C5, einen zweiten Kondensator C6, und einen Widerstand R3.

Die Widerstände der jeweiligen HF-Filtereinrichtungen sind jeweils in eine der Leitungen der Leitungspaare L1, L2, ... Ln eingefügt. Diese Leitung ist im betrachteten Beispiel diejenige Leitung, über welche das Modul, dem die jeweilige HF-Filtereinrichtung zugeordnet ist, mit der das Potential VCC führenden Versorgungsleitung V1 verbunden ist.

Die Kondensatoren der jeweiligen HF-Filtereinrichtungen sind jeweils zwischen den einzelnen Leitungen der Leitungspaare L1, L2, ... L3 angeordnet, über welche das Modul, dem die jeweilige HF-Filtereinrichtung zugeordnet ist, mit den Versorgungsleitungen V1 und V2 verbunden ist. Dabei befinden sich die jeweils ersten Kondensatoren der HF-Filtereinrichtungen, d.h. die Kondensatoren C1, C3 und C5 zwischen dem Widerstand der jeweiligen HF-Filtereinrichtung und dem Modul, dem die betreffende HF-Filtereinrichtung zugeordnet ist, und die jeweils zweiten Kondensatoren der HF-Filtereinrichtungen, d.h. die Kondensatoren C2, C4 und C6 zwischen dem Widerstand der jeweiligen HF-Filtereinrichtung und den Versorgungsleitungen V1 und V2.

Die HF-Filtereinrichtungen sind vorzugsweise sehr nahe (so nahe wie möglich) an den Modulen angeordnet, denen die jeweilige HF-Filtereinrichtung zugeordnet ist.

Die jeweils ersten Kondensatoren der HF-Filtereinrichtungen, d.h. die Kondensatoren C1, C3 und C5, und die Widerstände R1, R2, und R3 bilden jeweils einen Tiefpaß, durch den zumindest teilweise verhindert wird, daß über die Leitungspaare L1, L2, und Ln hochfrequente Störsignale in die Module M1, M2, ... Mn hineingelangen.

Die jeweils zweiten Kondensatoren der HF-Filtereinrichtungen, d.h. die Kondensatoren C2, C4 und C6, und die Widerstände R1, R2, und R3 bilden jeweils einen Tiefpaß, durch den zumindest teilweise verhindert wird, daß hochfrequente Störsignale, die in den Modulen M1, M2, ... Mn erzeugt werden, über die Leitungspaare L1, L2, und Ln auf die Versorgungsleitungen V1 und V2 und über diese zu anderen Bestandteilen der integrierten Schaltung oder nach außerhalb der integrierten Schaltung (zu anderen Komponenten des die integrierte Schaltung enthaltenden Systems) gelangen.

Durch die HF-Filtereinrichtungen wird damit sowohl ein Übertragen hochfrequenter Störungen zu den Modulen hin, als auch ein Übertragen hochfrequenter Störungen von den Modulen weg verhindert oder eingeschränkt.

Die jeweils ersten Kondensatoren der HF-Filtereinrichtungen, d.h. die Kondensatoren C1, C3, und C5 sind vorzugsweise so dimensioniert, daß die Energie, die den jeweiligen Modulen zugeführt werden muß, bei regelmäßiger oder kontinuierlicher Nachladung der Kondensatoren über die zwischen den ersten Kondensatoren C1, C3, bzw. C5 und den Versorgungsleitungen V1 und V2 verlaufenden Abschnitte der Leitungspaare L1, L2, ... Ln und die Widerstände R1, R2, ... Rn vollständig aus den ersten Kondensatoren entnommen werden kann.

Die Widerstände R1, R2, und R3 sind vorzugsweise so dimensioniert,
- daß einerseits die Ströme, die über diese fließen, groß genug sind, um die Module mit der von ihnen benötigten Energie zu versorgen (um die ersten Kondensatoren C1, C3, und C5 so aufzuladen, daß ihnen die von den Modulen benötigte Energie entnommen werden kann), und
- daß andererseits das Fließen hochfrequenter Ströme zwischen den Modulen und den Versorgungsleitungen durch die durch die Widerstände und die ersten Kondensatoren sowie durch die Widerstände und die zweiten Kondensatoren gebildeten Tiefpässe gänzlich unterbunden oder zumindest stark eingeschränkt werden.

Die Widerstände erweisen sich nicht nur als vorteilhaft, weil sie zusammen mit den Kondensatoren Tiefpässe bilden. Bei geeigneter Dimensionierung sorgen sie auch dafür, daß Resonanzen, die die Kondensatoren mit dem restlichen System und untereinander bilden, auf ein akzeptables Maß reduziert werden. Ferner wandeln sie einen Teil der durch die HF-Filtereinrichtung herauszufilternden hochfrequenten Störsignale in Wärme um, wodurch die Energie, die durch die integrierte Schaltung oder das die integrierte Schaltung enthaltende System im HF-Bereich abgestrahlt wird, reduziert werden kann. Berücksichtigt man diese Punkte beim Entwurf der HF-Filtereinrichtung, so erweist sich diese als besonders wirkungsvoll.

Der in der Figur gezeigte und vorstehend beschriebene Aufbau bietet einen optimalen Schutz vor der Ausbreitung von hochfrequenten Störsignalen über Gleichspannungen oder niederfrequente Spannungen führende Leitungen von und zu der integrierten Schaltung (den einzelnen Modulen derselben) und sonstigen Komponenten des die integrierte Schaltung enthaltenden Systems. Eine zwar nicht ganz so hervorragende, aber immer noch gute Schutzwirkung ergibt sich,
- wenn in einzelnen oder allen HF-Filtereinrichtungen der zweite Kondensator, d.h. der Kondensator C2, C4 oder C6 weggelassen wird, die HF-Filtereinrichtungen also nur noch aus dem ersten Kondensator und dem Widerstand bestehen, oder
- wenn in einzelnen oder allen HF-Filtereinrichtungen der erste Kondensator, d.h. der Kondensator C1, C3 oder C5 weggelassen wird, die HF-Filtereinrichtungen also nur noch aus dem zweiten Kondensator und dem Widerstand bestehen, oder
- wenn in einzelnen oder allen HF-Filtereinrichtungen der zweite Kondensator und zusätzlich auch noch der Widerstand weggelassen werden, die HF-Filtereinrichtungen also nur noch aus dem ersten Kondensator bestehen.

Es dürfte einleuchten, daß die beschriebene integrierte Schaltung mannigfaltig modifizierbar ist.

Insbesondere besteht keine Einschränkung darauf, daß durch die HF-Filtereinrichtungen die Ausbreitung von hochfrequenten Störsignalen über die zur Stromversorgung dienenden Versorgungsleitungen unterbunden oder eingeschränkt wird. Durch HF-Filtereinrichtungen der vorstehend beschriebenen Art kann auch die Ausbreitung von hochfrequenten Störsignalen über beliebige andere Gleichspannungen oder niederfrequente Spannungen führende Leitungen unterbunden oder eingeschränkt werden.

Es besteht ferner keine Einschränkung darauf, daß pro Modul genau eine HF-Filtereinrichtung vorgesehen ist. Grundsätzlich können für die einzelnen Module unabhängig voneinander beliebig viele HF-Filtereinrichtungen vorgesehen werden.

Des weiteren besteht keine Einschränkung hinsichtlich der Anzahl und des Inhaltes der Module der integrierten Schaltung. Es können beliebig viele Module vorgesehen sein, und diese können unabhängig voneinander beliebig groß sein und beliebige Bestandteile der integrierten Schaltung umfassen.

Schließlich besteht auch keine Einschränkung darauf, daß die integrierte Schaltung mehrere Module aufweist. HF-Filtereinrichtungen der beschriebenen Art lassen sich auch bei beliebig anders aufgebauten integrierten Schaltungen vorteilhaft einsetzen.

Die Integration einer HF-Filtereinrichtung in eine integrierte Schaltung ist unabhängig von den Einzelheiten der praktischen Realisierung der integrierten Schaltung und der HF-Filtereinrichtung eine sehr einfache, aber dennoch sehr wirkungsvolle Möglichkeit, um zu verhindern, daß der Betrieb der integrierten Schaltung durch hochfrequente Störsignale gestört wird und/oder daß andere integrierte Schaltungen oder sonstige Systemkomponenten durch von der integrierten Schaltung erzeugte hochfrequente Störsignale gestört werden.

### Bezugszeichenliste

- Cx: Kondensatoren
- Fx: HF-Filtereinrichtungen
- Mx: Module der integrierten Schaltung
- Lx: Leitungspaare zur Verbindung von F und V bzw. M und V
- Rx: Widerstände
- Vx: Versorgungsleitungen

## Patentansprüche

1. Integrierte Schaltung, in welcher eine HF-Filtereinrichtung (F1-Fn) integriert ist, durch die die Ausbreitung von hochfrequenten Störsignalen über Gleichspannungen oder niederfrequente Spannungen führende Leitungen (V1, V2, L1-Ln) unterbindbar oder einschränkbar ist,
wobei die HF-Filtereinrichtung (F1-Fn) einen ersten Kondensator (C1; C3; C5) und einen Widerstand (R1; R2; R3) umfaßt,
- wobei der erste Kondensator (C1; C3; C5) die Leitung (V1, V2, L1-Ln), von welcher die HF-Filtereinrichtung die hochfrequenten Störsignale entfernen soll, mit einem Bezugspotential (GND) verbindet, und
- wobei der Widerstand (R1; R2; R3) in die Leitung (V1, V2, L1-Ln), von welcher die HF-Filtereinrichtung die hochfrequenten Störsignale entfernen soll, eingefügt ist, **dadurch gekennzeichnet, daß** die HF-Filtereinrichtung einen zweiten Kondensator (C2; C4; C6) umfaßt,
- wobei der zweite Kondensator (C2; C4; C6) die Leitung (V1, V2, L1-Ln), von welcher die HF-Filtereinrichtung die hochfrequenten Störsignale entfernen soll, mit einem Bezugspotential (GND) verbindet, und
wobei des Widerstand (R1; R2; R3) zwischen dem ersten Kondensator (C1;C2;C3) und dem zweiten kondensator (C2; C4; C6) eingefügt ist.

2. Integrierte Schaltung nach Anspruch 1,
**dadurch gekennzeichnet,**
**daß** die HF-Filtereinrichtung (F1-Fn) so angeordnet, aufgebaut und dimensioniert ist, daß durch sie hochfrequente Störsignale herausgefiltert werden, die vor hochfrequenten Störsignalen zu schützenden Teilen (M1-Mn) der integrierten Schaltung über Gleichspannungen oder niederfrequente Spannungen führende Leitungen (V1, V2, L1-Ln) zugeführt werden.

3. Integrierte Schaltung nach Anspruch 1 oder 2,
**dadurch gekennzeichnet,**
**daß** die HF-Filtereinrichtung (F1-Fn) so angeordnet, aufgebaut und dimensioniert ist, daß durch sie hochfrequente Störsignale herausgefiltert werden, die aus hochfrequente Störsignale erzeugenden Teilen (M1-Mn) der integrierten Schaltung über Gleichspannungen oder niederfrequente Spannungen führende Leitungen (V1, V2, L1-Ln) ausgegeben werden.

4. Integrierte Schaltung nach einem der vorhergehenden Ansprüche,
**dadurch gekennzeichnet,**
**daß** die HF-Filtereinrichtung (F1-Fn) so angeordnet, aufgebaut und dimensioniert ist, daß vor hochfrequenten Störsignalen zu schützende Teile (M1-Mn) der integrierten Schaltung auch vor hochfrequenten Störsignalen geschützt werden, die innerhalb der integrierten Schaltung erzeugt werden.

5. Integrierte Schaltung nach einem der vorhergehenden Ansprüche,
**dadurch gekennzeichnet,**
**daß** die HF-Filtereinrichtung (F1-Fn) in unmittelbarerer Nähe der Teile (M1-Mn) der integrierten Schaltung angeordnet ist, die vor den hochfrequenten Störsignalen zu schützen sind und/oder vor deren hochfrequenten Störsignalen andere Teile (M1-Mn) der integrierten Schaltung oder des die integrierte Schaltung enthaltenden Systems zu schützen sind.

6. Integrierte Schaltung nach einem der vorhergehenden Ansprüche,
**dadurch gekennzeichnet,**
**daß** die HF-Filtereinrichtung (F1-Fn) so angeordnet, aufgebaut und dimensioniert ist, daß durch sie hochfrequente Störsignale herausgefiltert werden, die über Leitungen (V1, V2, L1-Ln) übertragen werden, über welche die Teile (M1-Mn) der integrierten Schaltung, die vor hochfrequenten Störsignalen geschützt werden sollen, und/oder vor deren hochfrequenten Störsignalen andere Teile (M1-Mn) der integrierten Schaltung oder des die integrierte Schaltung enthaltenden Systems zu schützen sind, mit der zum Betrieb benötigten Energie versorgt werden.

7. Integrierte Schaltung nach einem der vorhergehenden Ansprüche,
**dadurch gekennzeichnet,**
**daß** der Widerstand (R1; R2; R3) und der erste Kondensator (C1; C3; C5) einen Tiefpaß bilden, durch welchen zumindest teilweise verhindert wird, daß hochfrequente Störsignale in die Teile (M1-Mn) der integrierten Schaltung gelangen, die durch die HF-Filtereinrichtung (F1-Fn) vor hochfrequenten Störsignalen zu schützen sind, und/oder vor deren hochfrequenten Störsignalen andere Teile (M1-Mn) der integrierten Schaltung oder des die integrierte Schaltung enthaltenden Systems zu schützen sind.

8. Integrierte Schaltung nach einem der vorhergehenden Ansprüche,
**dadurch gekennzeichnet,**
**daß** der Widerstand (R1; R2; R3) und der zweite Kondensator (C2; C4; C6) einen Tiefpaß bilden, durch welchen zumindest teilweise verhindert wird, daß hochfrequente Störsignale aus den Teilen (M1-Mn) der integrierten Schaltung gelangen, die durch die HF-Filtereinrichtung (F1-Fn) vor hochfrequenten Störsignalen zu schützen sind, und/oder vor deren hochfrequenten Störsignalen andere Teile (M1-Mn) der integrierten Schaltung oder des die integrierte Schaltung enthaltenden Systems zu schützen sind.

9. Integrierte Schaltung nach einem der vorhergehenden Ansprüche,
**dadurch gekennzeichnet,**
**daß** der erste Kondensator (C1; C3; C5) so dimensioniert ist, daß die Energie, die den Teilen (M1-Mn) der integrierten Schaltung, die durch die HF-Filtereinrichtung (F1-Fn) vor hochfrequenten Störsignalen zu schützen sind, und/oder vor deren hochfrequenten Störsignalen andere Teile (M1-Mn) der integrierten Schaltung oder des die integrierte Schaltung enthaltenden Systems zu schützen sind, über die mit der HF-Filtereinrichtung versehenen Leitungen (V1, V2, L1-Ln) zuzuführen ist, bei regelmäßiger oder kontinuierlicher Nachladung des ersten Kondensators vollständig aus diesem entnommen werden kann.

10. Integrierte Schaltung nach Anspruch 9,
**dadurch gekennzeichnet,**
**daß** der Widerstand (R1; R2; R3) so dimensioniert ist, daß der Strom, der während des Betriebes der integrierten Schaltung über ihn fließt, ausreicht, um den ersten Kondensator (C1; C3; C5) ständig so weit aufgeladen zu halten, daß die Energie, die den Teilen (M1-Mn) der integrierten Schaltung, die durch die HF-Filtereinrichtung (F1-Fn) vor hochfrequenten Störsignalen zu schützen sind, und/oder vor deren hochfrequenten Störsignalen andere Teile (M1-Mn) der integrierten Schaltung oder des die integrierte Schaltung enthaltenden Systems zu schützen sind, über die mit der HF-Filtereinrichtung versehenen Leitungen (V1, V2, L1-Ln) zuzuführen ist, vollständig aus dem ersten Kondensator entnommen werden kann.

11. Integrierte Schaltung nach einem der vorhergehenden Ansprüche,
**dadurch gekennzeichnet,**
**daß** der Widerstand (R1; R2; R3) so dimensioniert ist, daß die Tiefpässe, an deren Bildung der Widerstand beteiligt ist, das Fließen hochfrequenter Störsignale gänzlich unterbinden oder zumindest stark einschränken.

12. Integrierte Schaltung nach einem der vorhergehenden Ansprüche,
**dadurch gekennzeichnet,**
**daß** der Widerstand (R1; R2; R3) so dimensioniert ist, daß Resonanzen, die die Kondensatoren (C1, C2; C3, C4; C5, C6) mit dem restlichen System und untereinander bilden, auf ein den Betrieb der integrierten Schaltung nicht störendes Maß reduziert werden.

13. Integrierte Schaltung nach einem der vorhergehenden Ansprüche,
**dadurch gekennzeichnet,**
**daß** der Widerstand (R1; R2; R3) so dimensioniert ist, daß er die durch die HF-Filtereinrichtung (F1-F3) herauszufilternden hochfrequenten Störsignale zumindest teilweise in Wärme umwandelt.

14. Integrierte Schaltung nach einem der vorhergehenden Ansprüche,
**dadurch gekennzeichnet,**
**daß** die integrierte Schaltung mehrere HF-Filtereinrichtungen (F1-Fn) aufweist, wobei die mehreren HF-Filtereinrichtungen verschiedenen Teilen (M1-Mn) der integrierten Schaltung zugeordnet sind.

## Claims

1. Integrated circuit, in which there is integrated an RF filter device (F1-Fn) which can prevent or restrict the propagation of high-frequency interference signals via lines (V1, V2, L1-Ln) carrying DC voltages or low-frequency voltages, the RF filter device (F1-Fn) comprising a first capacitor (C1; C3; C5) and a resistor (R1; R2; R3),
- the first capacitor (C1; C3; C5) connecting the line (V1, V2, L1-Ln) from which the RF filter device is intended to remove the high-frequency interference signals to a reference-ground potential (GND), and
- the resistor (R1; R2; R3) being inserted into the line (V1, V2, L1-Ln) from which the RF filter device is intended to remove the high-frequency interference signals, **characterized in that** the RF filter device comprises a second capacitor (C2; C4; C6),
the second capacitor (C2; C4; C6) connecting the line (V1, V2, L1-Ln) from which the RF filter device is intended to remove the high-frequency interference signals to a reference-ground potential (GND), and
the resistor (R1; R2; R3) being inserted between the first capacitor (C1; C3; C5) and the second capacitor (C2; C4; C6).

2. Integrated circuit according to Claim 1,
**characterized**
**in that** the RF filter device (F1-Fn) is arranged, constructed and dimensioned in such a way that it filters out high-frequency interference signals which are fed to parts (M1-Mn) of the integrated circuit that are to be protected against high-frequency interference signals via lines (V1, V2, L1-Ln) carrying DC voltages or low-frequency voltages.

3. Integrated circuit according to Claim 1 or 2,
**characterized**
**in that** the RF filter device (F1-Fn) is arranged, constructed and dimensioned in such a way that it filters out high-frequency interference signals which are output from parts (M1-Mn) of the integrated circuit that generate high-frequency interference signals via lines (V1, V2, L1-Ln) carrying DC voltages or low-frequency voltages.

4. Integrated circuit according to one of the preceding claims,
**characterized**
**in that** the RF filter device (F1-Fn) is arranged, constructed and dimensioned in such a way that parts (M1-Mn) of the integrated circuit that are to be protected against high-frequency interference signals are also protected against high-frequency interference signals which are generated within the integrated circuit.

5. Integrated circuit according to one of the preceding claims,
**characterized**
**in that** the RF filter device (F1-Fn) is arranged in direct proximity to the parts (M1-Mn) of the integrated circuit which are to be protected against the high-frequency interference signals and/or against whose high-frequency interference signals other parts (M1-Mn) of the integrated circuit or of the system containing the integrated circuit are to be protected.

6. Integrated circuit according to one of the preceding claims,
**characterized**
**in that** the RF filter device (F1-Fn) is arranged, constructed and dimensioned in such a way that it filters out high-frequency interference signals which are transmitted via lines (V1, V2, L1-Ln) via which the parts (M1-Mn) of the integrated circuit which are intended to be protected against high-frequency interference signals, and/or against whose high-frequency interference signals other parts (M1-Mn) of the integrated circuit or of the system containing the integrated circuit are to be protected, are supplied with the energy required for operation.

7. Integrated circuit according to one of the preceding claims,
**characterized**
**in that** the resistor (R1; R2; R3) and the first capacitor (C1; C3; C5) form a low-pass filter which at least partially prevents high-frequency interference signals from reaching the parts (M1-Mn) of the integrated circuit which are to be protected against high-frequency interference signals by the RF filter device (F1-Fn), and/or against whose high-frequency interference signals other parts (M1-Mn) of the integrated circuit or of the system containing the integrated circuit are to be protected.

8. Integrated circuit according to one of the preceding claims,
**characterized**
**in that** the resistor (R1; R2; R3) and the second capacitor (C2; C4; C6) form a low-pass filter which at least partially prevents high-frequency interference signals from reaching the parts (M1-Mn) of the integrated circuit which are to be protected against high-frequency interference signals by the RF filter device (F1-Fn), and/or against whose high-frequency interference signals other parts (M1-Mn) of the integrated circuit or of the system containing the integrated circuit are to be protected.

9. Integrated circuit according to one of the preceding claims,
**characterized**
**in that** the first capacitor (C1; C3; C5) is dimensioned in such a way that the energy which is to be fed via the lines (V1, V2, L1-Ln) provided with the RF filter device to the parts (M1-Mn) of the integrated circuit which are to be protected against high-frequency interference signals by the RF filter device (F1-Fn) and/or against whose high-frequency interference signals other parts (M1-Mn) of the integrated circuit or of the system containing the integrated circuit are to be protected can be drawn completely from the first capacitor given regular or continuous recharging of the latter.

10. Integrated circuit according to Claim 9,
**characterized**
**in that** the resistor (R1; R2; R3) is dimensioned in such a way that the current which flows via it during operation of the integrated circuit suffices to keep the first capacitor (C1; C3; C5) continually charged to such an extent that the energy which is to be fed via the lines (V1, V2, L1-Ln) provided with the RF filter device to the parts (M1-Mn) of the integrated circuit which are to be protected against high-frequency interference signals by the RF filter device (F1-Fn) and/or against whose high-frequency interference signals other parts (M1-Mn) of the integrated circuit or of the system containing the integrated circuit are to be protected can be drawn completely from the first capacitor.

11. Integrated circuit according to one of the preceding claims,
**characterized**
**in that** the resistor (R1; R2; R3) is dimensioned in such a way that the low-pass filters in whose formation the resistor is involved entirely prevent or at least greatly restrict the flowing of high-frequency interference signals.

12. Integrated circuit according to one of the preceding claims,
**characterized**
**in that** the resistor (R1; R2; R3) is dimensioned in such a way that resonances which the capacitors (C1, C2; C3, C4; C5, C6) form with the rest of the system and among one another are reduced to a degree which does not interfere with the operation of the integrated circuit.

13. Integrated circuit according to one of the preceding claims,
**characterized**
**in that** the resistor (R1; R2; R3) is dimensioned in such a way that it converts the high-frequency interference signals that are to be filtered out by the RF filter device (F1-F3) at least partially into heat.

14. Integrated circuit according to one of the preceding claims,
**characterized**
**in that** the integrated circuit has a plurality of RF filter devices (F1-Fn), the plurality of RF filter devices being assigned to different parts (M1-Mn) of the integrated circuit.

## Revendications

1. Circuit intégré dans lequel est intégré un dispositif de filtrage HF (F1-Fn) qui permet d'inhiber ou de limiter la propagation des signaux parasites à haute fréquence par le biais des lignes (V1, V2, L1-Ln) qui transportent des tensions continues ou des tensions à fréquence plus basse, le dispositif de filtrage HF (F1-Fn) comprenant un premier condensateur (C1 ; C3 ; C5) et une résistance (R1 ; R2 ; R3), le premier condensateur (C1 ; C3 ; C5) reliant la ligne (V1, V2, L1-Ln), de laquelle le dispositif de filtrage HF doit supprimer les signaux parasites à haute fréquence, à un potentiel de référence (GND), et la résistance (R1 ; R2 ; R3) étant insérée dans la ligne (V1, V2, L1-Ln) de laquelle le dispositif de filtrage HF doit supprimer les signaux parasites à haute fréquence, **caractérisé en ce que** le dispositif de filtrage HF comprend un deuxième condensateur (C2 ; C4 ; C6), le deuxième condensateur (C2 ; C4 ; C6) reliant la ligne (V1, V2, L1-Ln), de laquelle le dispositif de filtrage HF doit supprimer les signaux parasites à haute fréquence, à un potentiel de référence (GND), la résistance (R1 ; R2 ; R3) étant insérée entre le premier condensateur (C1 ; C3 ; C5) et le deuxième condensateur (C2 ; C4 ; C6).

2. Circuit intégré selon la revendication 1, **caractérisé en ce que** le dispositif de filtrage HF (F1-Fn) est disposé, construit et dimensionné de telle sorte qu'il élimine par filtrage les signaux parasites à haute fréquence qui sont acheminés aux parties (M1-Mn) du circuit intégré à protéger contre les signaux parasites à haute fréquence par le biais des lignes (V1, V2, L1-Ln) qui transportent des tensions continues ou des tensions à fréquence plus basse.

3. Circuit intégré selon la revendication 1 ou 2, **caractérisé en ce que** le dispositif de filtrage HF (F1-Fn) est disposé, construit et dimensionné de telle sorte qu'il élimine par filtrage les signaux parasites à haute fréquence qui sont délivrés par les parties (M1-Mn) du circuit intégré produisant des signaux parasites à haute fréquence par le biais des lignes (V1, V2, L1-Ln) qui transportent des tensions continues ou des tensions à fréquence plus basse.

4. Circuit intégré selon l'une des revendications précédentes, **caractérisé en ce que** le dispositif de filtrage HF (F1-Fn) est disposé, construit et dimensionné de telle sorte que les parties (M1-Mn) du circuit intégré à protéger contre les signaux parasites à haute fréquence sont également protégées contre les signaux parasites à haute fréquence qui sont produits à l'intérieur du circuit intégré.

5. Circuit intégré selon l'une des revendications précédentes, **caractérisé en ce que** le dispositif de filtrage HF (F1-Fn) est disposé à proximité immédiate des parties (M1-Mn) du circuit intégré qui doivent être protégées contre les signaux parasites à haute fréquence et/ou contre les signaux parasites à haute fréquence desquelles il faut protéger d'autres parties (M1-Mn) du circuit intégré ou du système qui contient le circuit intégré.

6. Circuit intégré selon l'une des revendications précédentes, **caractérisé en ce que** le dispositif de filtrage HF (F1-Fn) est disposé, construit et dimensionné de telle sorte qu'il élimine par filtrage les signaux parasites à haute fréquence qui sont transmis par les lignes (V1, V2, L1-Ln) par le biais desquelles les parties (M1-Mn) du circuit intégré qui doivent être protégées contre les signaux parasites à haute fréquence et/ou contre les signaux parasites à haute fréquence desquelles il faut protéger d'autres parties (M1-Mn) du circuit intégré ou du système qui contient le circuit intégré sont alimentées avec l'énergie nécessaire à leur fonctionnement.

7. Circuit intégré selon l'une des revendications précédentes, **caractérisé en ce que** la résistance (R1 ; R2 ; R3) et le premier condensateur (C1 ; C3 ; C5) forment un filtre passe-bas qui permet au moins partiellement d'éviter que des signaux parasites à haute fréquence parviennent dans des parties (M1-Mn) du circuit intégré qui doivent être protégées par le dispositif de filtrage HF (F1-Fn) contre les signaux parasites à haute fréquence et/ou contre les signaux parasites à haute fréquence desquelles il faut protéger d'autres parties (M1-Mn) du circuit intégré ou du système qui contient le circuit intégré.

8. Circuit intégré selon l'une des revendications précédentes, **caractérisé en ce que** la résistance (R1 ; R2 ; R3) et le deuxième condensateur (C2 ; C4 ; C6) forment un filtre passe-bas qui permet au moins partiellement d'éviter que des signaux parasites à haute fréquence parviennent dans des parties (M1-Mn) du circuit intégré qui doivent être protégées par le dispositif de filtrage HF (F1-Fn) contre les signaux parasites à haute fréquence et/ou contre les signaux parasites à haute fréquence desquelles il faut protéger d'autres parties (M1-Mn) du circuit intégré ou du système qui contient le circuit intégré.

9. Circuit intégré selon l'une des revendications précédentes, **caractérisé en ce que** le premier condensateur (C1 ; C3 ; C5) est dimensionné de telle sorte que l'énergie qui doit être acheminée aux parties (M1-Mn) du circuit intégré qui doivent être protégées par le dispositif de filtrage HF (F1-Fn) contre les signaux parasites à haute fréquence et/ou contre les signaux parasites à haute fréquence desquelles il faut protéger d'autres parties (M1-Mn) du circuit intégré ou du système qui contient le circuit intégré par le biais des lignes (V1, V2, L1-Ln) munies du dispositif de filtrage HF peut être totalement prélevée de celui-ci si le premier condensateur est régulièrement ou continuellement rechargé.

10. Circuit intégré selon la revendication 9, **caractérisé en ce que** la résistance (R1 ; R2 ; R3) est dimensionnée de telle sorte que le courant qui traverse le circuit intégré pendant son fonctionnement est suffisant pour maintenir continuellement le premier condensateur (C1 ; C3 ; C5) à une charge suffisante pour que l'énergie qui doit être acheminée aux parties (M1-Mn) du circuit intégré qui doivent être protégées par le dispositif de filtrage HF (F1-Fn) contre les signaux parasites à haute fréquence et/ou contre les signaux parasites à haute fréquence desquelles il faut protéger d'autres parties (M1-Mn) du circuit intégré ou du système qui contient le circuit intégré par le biais des lignes (V1, V2, L1-Ln) munies du dispositif de filtrage HF peut être totalement prélevée du premier condensateur.

11. Circuit intégré selon l'une des revendications précédentes, **caractérisé en ce que** la résistance (R1 ; R2 ; R3) est dimensionnée de telle sorte que les filtres passe-bas dont la résistance fait partie de la structure inhibent totalement ou au moins restreignent fortement la circulation de signaux parasites à haute fréquence.

12. Circuit intégré selon l'une des revendications précédentes, **caractérisé en ce que** la résistance (R1 ; R2 ; R3) est dimensionnée de telle sorte que les résonances formées par les condensateurs (C1, C2 ; C3, C4 ; C5, C6) avec le reste du système sont réduites à un niveau qui ne perturbe pas le fonctionnement du circuit intégré.

13. Circuit intégré selon l'une des revendications précédentes, **caractérisé en ce que** la résistance (R1 ; R2 ; R3) est dimensionnée de telle sorte qu'elle convertit au moins partiellement en chaleur les signaux parasites à haute fréquence éliminés par filtrage par le dispositif de filtrage HF (F1-F3).

14. Circuit intégré selon l'une des revendications précédentes, **caractérisé en ce que** le circuit intégré présente plusieurs dispositifs de filtrage HF (F1-Fn), les plusieurs dispositifs de filtrage HF (F1-Fn) étant associés à différentes parties (M1-Mn) du circuit intégré.
